# EUROPEAN PATENT SPECIFICATION

(11) **EP 1 530 415 B1**
(45) Date of publication and mention of the grant of the patent: **15.08.2007**
(21) Application number: 03025830.5
(22) Date of filing: 10.11.2003
(51) Int. Cl.: H05K 13/02

(54) **Exposure member and tape guide at a component mounting machine**
Aussetzungsvorrichtung und Bandführungsvorrichtung für eine Bauteilbestückungsmaschine
Dispositif de mettre à découvert et guide bande pour une machine de montage de composants

(43) Date of publication of application: 11.05.2005
(73) Proprietor: Mydata Automation AB, 168 66 Bromma (SE)
(72) Inventor: Bergström, Johan, 16732 Bromma (SE); Larsson, Andreas, 41102 Göteborg (SE); Yman, Niclas, 17852 Ekerö (SE)
(74) Representative: Skagersten, Thomas

(56) References cited:
- JP-A- 2000 269 686
- US-A1- 2003 051 821

## Description

### Technical field of the invention

The present invention generally relates to the field of manufacture and assembly of circuit boards. More specifically, the present invention relates to an exposure member for exposing components at a picking position in a component mounting machine, and a tape guide comprising such an exposure member.

### Technical background

Generally, within the field of manufacture and assembly of circuit boards, electronic components are fed to a component mounting machine for mechanically and/or electrically mounting the components onto a circuit board. These surface mounted components are often delivered spaced apart along the length of a component tape. Generally, two different types of component tapes are used. The first type consists of a lower carrier tape, preferably plastic, provided with component holding compartments, which are enclosed by a separable, thin, plastic upper cover, or cover tape or protective tape. The second type consists of a cardboard body provided with through holes. The body is provided with separable, thin, plastic, top and bottom covers, thus forming component compartments with the through holes. For ease of description, the term cover will hereinafter refer only to the top cover, since the bottom cover is generally not removed during the component mounting process. Consequently, the term carrier tape will hereinafter also refer to the cardboard body with the bottom cover provided thereon.

The component tapes are further provided with a lateral portion, extending next to the compartments along the entire length of the component tape, provided with through holes. These through holes are used for engagement with an element of a feeding device of suitable type, the feeding device feeding the component tape into position for picking of components from the tape.

The cover is generally sealed to the carrier tape by providing portions on either or both of the cover and the carrier tape with adhesive, or portions where the cover is fused to the carrier tape. These portions of attachment between the carrier tape and the cover are elongated and run along the entire extension of the component tape, along and adjacent to each side of the component compartments. Generally, the attachment portions are positioned as close to the compartments as possible without the risk of the adhesive coming into contact with the components, since contact could lead to component contamination and malfunctions of the mounting process. On the other hand, a large distance between the attachment portions and the compartments when dealing with very small components could leave room for the components to escape from the compartments even though the cover is still attached to the carrier tape. Of course, this could also lead to serious malfunctions.

According to a recent method for exposing and picking a component from a component tape, a particular type of tape guide is used for bringing the component tape in position for feeding the component tape by interaction with a feeding device, and for picking of components from the tape. The tape guide is provided with an exposure member arranged for exposing the components at a picking position. The exposure member has the general form of a plough, which is arranged to detach one of the attachment portions of the cover, which is attached to the component tape, but to leave the other attachment portion still attached, and as the cover is fed further into the tape guide, the cover is brought aside of the compartment, thereby completely exposing the component at the picking position. A more detailed description of such a tape guide and the methods of using such a tape guide are disclosed in WO 00/38491, which is incorporated herein by reference.

At present, there are a wide variety of different configurations for component tapes, for instance different component tape widths, but also different configurations for component tapes of the same width. The compartments are formed as regards size and shape in adaptation to the components they are intended to accommodate. There must be sufficient space for accommodating the component, at the same time as there is a desire for the compartments to be small for limiting the movement of the component within the compartment, and for providing as many compartments as possible on the component tape. Also, the positions of the compartments, or rather the distance between the compartments, may vary, as may the features of the covers. Since the compartment sizes vary, especially the width of the compartments, the lateral positions of the attachment positions must vary, as explained above. However, the majority of components are provided on component tapes having a width selected from a few standardized component tape widths, the most commonly used being 8, 12 and 16 mm tapes.

Generally, each compartment contains one component only. According to standardization protocols, the transversal centre of each compartment is positioned at a defined distance from the lateral edge of the component tape. Thus, the distance from the lateral edge of the compartment to the lateral side of the component tape varies in accordance with the width of the compartment. Generally, the areas where the cover is attached to the carrier tape are positioned immediately adjacent to the lateral side of each compartment, i.e. between the compartment and the lateral edges of the component tape. For component tapes with very small compartments, these areas may be provided slightly spaced apart from the edges of the compartments. Furthermore, the width of the cover is generally the same for component tapes of the same width. However, there are exceptions where the width of the cover is varied within the same component tape width, essentially in correspondence with the width of the compartments.

EP 1 298 977 discloses a solution to the problem of handling components provided on differently configured component tapes having the same component tape widths. In this application, there is disclosed a system comprising, inter alia, a plurality if tape guides with similar geometrical outline, i.e. all being arranged to receive component tapes of the same component tape width, and comprising component exposure member of different configurations in adaptation to the differently configured component tapes. However, for a given number of component tapes of the same width, a larger number of tape guides are required in order to be certain to accommodate all of the varying component tape configurations that might be used.

### Summary of the invention

An object of the present invention is to provide an alternative solution to the problem of handling components provided on differently configured component tapes having the same component tape widths.

This and other objects are achieved according to the present invention by providing an exposure member having the features defined in the independent claim. The invention also includes a tape guide comprising such an exposure member. Preferred embodiments are defined in the dependent claims.

For the purpose of clarity, the term "lateral" refers to the lateral direction of the component tape, i.e. perpendicular to the feeding direction thereof. Furthermore, the "distal" direction is the feeding direction of the component tape and the "proximal" direction is the opposite direction.

The present invention is based on the insight of providing, for component tapes of the same width, an exposure member, arranged for separating a cover from a carrier tape along a first attachment portion while leaving the cover attached to the carrier tape along a second attachment portion and for bringing the cover to one side of the compartment at the picking position, that may be adjusted in adaptation to the various component tape configurations. Thereby, the same exposure member may be used for component tapes of the same component tape width regardless of the actual configuration of the carrier tape, the cover and the attachment thereof for the component tape. Consequently, a single tape guide, comprising the adjustable exposure member, may be used for all component tapes of the same component tape width independent of the types and sizes of different components to be handled and, in turn, of the configuration of the component tape on which they are provided.

A most significant advantage of such a solution is that the need for "over capacity" of different component exposure member in order to accommodate different component tapes of the same component tape width is practically eliminated. Instead, only the number of tape guides corresponding to the number of component tapes used, or prepared for subsequent use, are required.

The present invention is particularly advantageous in embodiments where the exposure member is comprised in a tape guide provided as a self-contained separate unit. Using such tape guide units, arranged to be readily mounted into and removed from a component mounting machine or a magazine for use at a component mounting machine, component tapes can be connected to and electronically associated with the tape guides in advance, and stored while waiting to be used in a later component mounting process. Since this requires a larger number of tape guides and corresponding exposure members than are actually needed in the on-going component mounting processes, the obtained over capacity reduction is even more significant.

Furthermore, the provision of tape guide units having adjustable exposure members completely eliminates the risk of the operator selecting a tape guide having a fixed exposure member that is not adapted to the particular configuration of the component tape in question. Such a mistake could lead to the component tape not being completely exposed, which could lead to the pick-up head dropping the component after picking and causing severe disruptions of the component mounting process. Alternatively, it could lead to the cover being separated from the carrier tape along both attachment portions of the component tape, the loose cover being at risk of getting tangled up with the pick-up head, which inevitably would lead to feeding malfunctioning and disruptions of the mounting process.

It should be noted that the present invention is not limited to be used in connection with tape guides provided as separate, self-contained units. For instance, adjustable exposure members could be provided in tape guides or feeders where a plurality of such tape guides or feeder are incorporated in component magazines or component trolleys. Then, the provision of adjustable exposure members of course reduces an otherwise required over capacity in component magazines and component trolleys.

According to preferred embodiments of the present invention, the feeding means for feeding the component tape towards the picking position is provided in the component mounting machine or in a component magazine for interaction with the machine. In other words, the tape guide is preferably free of any such feeding means. Thereby, the tape guide can be manufactured in a simple form, which significantly reduces manufacturing complexity and costs for the tape guide. Although preferred, the present invention is not limited to use in conjunction with tape guides lacking component tape feeding means.

It should be noted that the present invention is intended for use with component tapes having the same component tape width. However, the present invention is in no way restricted to a specific component tape width. On the contrary, it is equally applicable to component tapes of, for instance, 8, 12 or 16 mm width.

The exposure member of a tape guide of the present invention exposes a component by at least partly removing or displacing from the carrier tape the portion of the cover that covers the component. Preferably, this is performed by providing the exposure member with a separating portion that is brought into engagement with the component tape between the cover and the carrier tape, thus lifting the cover from the carrier tape. According to the present invention, the lateral position of the exposure member is adjustable in accordance with the configuration of the component tape, in such a manner that the separating portion is brought into engagement with the component tape at the correct position.

As mentioned above, the separating portion of the exposure member is brought into engagement with the component tape at a lateral portion of the cover only. Thereby, a portion of the cover will be separated from the carrier tape on one side only, i.e. the cover will remain attached to the carrier tape on the other side of the compartment. Preferably, the separating portion is located at a position that is adapted to the configuration of the component tapes for which it is intended, i.e. to the width of the component compartments, the width of the cover and the positions of the respective adhesive areas. The width and position of the separating portion being such that the cover is separated from the carrier tape at one adhesive area or portion, while leaving the adhesive on the other side of the compartment at least partially intact, such that the cover remains attached to the carrier tape on that side of the compartment.

Since the lateral centre of the compartments is always the same, and standardized as mentioned above, and thereby the lateral centre of the cover thereby is known, the exposure member, and the separating portion thereof may engage between the cover and the carrier tape the entire distance from the lateral centre to the lateral edge of the component tape. However, the initial engagement is preferably as close as possible to the lateral centre such that very small compartments may be exposed. Otherwise, there may be a risk of the separating portion attempting to engage between the cover and the carrier tape outside the attachment portions instead of between the attachment portions. Even if such an engagement in some instances could still effect a proper exposing of the component, it is preferred that the initial engagement between the exposure member and the component tape is between the attachment portions. Also, in order not to separate the cover from the carrier tape along both attachment portions, the separating portion is preferably adjustable to a position up to but not exceeding the lateral centre of the cover.

Preferably, the adjustable exposure member is laterally displaceable at the picking position from a position close to the lateral centre of the compartment, for exposing very small compartments, to a position close to, but not immediately adjacent, the longitudinal carrier tape portion that is provided with through holes for feeding of the component tape, in order to expose very large compartments that could extend almost to said through hole portion, since the intervening attachment portion must remain unaffected.

According to a preferred embodiment of the invention, the exposure member is pivotally adjustable about a pivot point at the proximal end of the exposure member, that is the end containing the separating portion. Thereby, upon adjustment of the exposure member, the separating portion may remain in virtually the same lateral position, while at the more distally located picking position, the lateral displacement of the exposure member is greater. Furthermore, the angle of the exposure member, i.e. of the surface thereof which effects the bringing of the cover completely to the side of the compartment, increases, which facilitates the action of displacing the cover a greater lateral distance from the separating point to the picking position.

Preferably, the adjustment means of the exposure member is located at the top of the tape guide for easy manual manipulation by an operator. Thus, no extra space is required at the side of the tape guide for accommodating the adjustment means. Thereby, a plurality of tape guides can be mounted immediately adjacent each other side by side in a component mounting machine, or in a component magazine for use with a component mounting machine, thus reducing the required overall machine size. Furthermore, the adjustment means is easily accessible even when the tape guide is mounted in position in a component magazine or a component mounting machine. Furthermore, this arrangement is also ergonomically advantageous since the operator, when the tape guide is not mounted, can easily effect the adjustment of the exposure member with one hand, i.e. by holding the tape guide with one hand and adjusting the exposure member with the thumb.

According to an embodiment of the invention, said adjustment means is in the form of an easily accessible adjustment wheel which engages the tape guide in threaded coupling via an adjusting screw. By turning the adjustment wheel, the exposure member will be laterally displaced, at least at the picking position. The displacement can be a lateral displacement of the entire exposure member, but is preferably a pivotal. Thereby, an adjustment of the exposure member may result in a greater lateral displacement distally, i.e. a greater lateral displacement at the picking position than at the point of initial engagement between the exposure member and the component tape.

In the preferred embodiment, the exposure member is fixedly mounted to the tape guide at a proximal end of the exposure member, which mounting also acts as a pivot point. The adjustment wheel is located distally of the pivot point, either between the pivot point and the picking position or beyond the picking position. Thus, by manipulating the adjustment wheel, the screw effects a pivotal movement of the exposure member such that the angle between the component tape and the exposure member as well as the lateral position of the exposure member at the picking position changes. Optionally, the wheel may be provided with visual markings for facilitating the task of adjusting the exposure member to a desired position. Furthermore, the adjustment wheel may be adjusted in distinct steps, which preferably is indicated through friction markings, for instance in the form of a so-called click-mechanism. According to another embodiment, the adjustment wheel is continuously adjustable, i.e. the exposure member may assume any position between the respective limit positions. Preferably, the setting of the adjustment wheel is maintained between subsequent adjustments by frictional coupling.

Furthermore, the exposure member is preferably provided with a scale that indicates the position of the exposure member. Thereby, the exposure member can be easily adjusted into desired setting values that are optimised to the configurations of the component tape in question. Preferably, the scale is provided at the distal end or the exposure member where the displacement of the exposure member is the greatest. Thereby, the readability of the scale improves and the operator may easily assess the current displacement of the exposure member.

According to a preferred embodiment, the scale of the exposure member is provided with measures corresponding to a certain measure of the component tapes, for instance the distance from the lateral edge of the component tape to the lateral edge of the compartments, i.e. across the compartments. This indicates the lateral distance the cover should be brought to the side at the picking position and provides a quick indication to the operator how to set the adjustment of the exposure member for a particular component tape.

According to embodiments of the invention, the exposure member comprises a covering portion, the longitudinal extension of which being adapted such that the compartment is covered by the covering portion from the point where the separation of the cover from the carrier tape commences up to the picking position. This is done in order to ensure that components provided in compartments which are in the process of being exposed, i.e. that are close to but not actually at the picking position and where the cover is at least partly removed, does not escape their compartments or get turned on the side or up-side down through vibrations of the feeding action. However, since the pitch of a component tape, i.e. the distance from the centre of one compartment to the centre of the adjacent or subsequent compartment differs, the exposure member according to this embodiment is provided with a removable lid member that is positioned immediately adjacent or partially covering the picking position. Thereby, the longitudinal extension, i.e. in the feeding direction of the component tape, of the covering portion is either increased, when the lid member is mounted, or reduced, when the lid member is removed.

For very small compartments, the standard pitch is reduced so that more components may be provided on each component tape, which entails that the distance between adjacent compartments may be very small. Preferably, the covering portion is then increased by having the lid portion mounted for reduced pitch compartments, such that the covering portion covers the component tape closer to the picking position and, thereby, covers the component to be subsequently picked.

For larger components and corresponding compartments, the lid member is removed. Thereby, the component tape is unexposed earlier as seen in the feeding direction. Thus, the covering portion will not interfere with the picking action, even though components are picked from compartments having a greater longitudinal extension. Consequently, the extension of the covering portion is varied in accordance with the size of the compartments, and to the components contained therein, for component tapes of the same component tape width, by having the lid member mounted or removed.

According to embodiments of the present invention, the exposure member is arranged such that when bringing the cover to the side of the compartment at the picking position, the cover is raised to an essentially upright position at the side of the compartment located at the picking position. Thus, the portion of the cover brought aside is provided with a very narrow lateral extension at the picking position. Thus, the width of the tape guide may be kept advantageously narrow, in fact only just exceeding the width of the component tapes for which it is intended.

According to alternative embodiments of the present invention, the cover is folded during said raising of the cover to an essentially upright position. This is in order to reduce the height of the raised cover when handling wider component tapes having wide covers that are to be raised to an upright position at the picking position. If the cover is not folded, a substantial amount of free space is required above the component tapes at the picking position for preventing the height of the raised cover to interfere with the movements of the pick-up head. However, such free space will force the pick-up head to travel an unnecessarily long vertical distance when first avoiding the raised cover and then descending to pick up the component. Preferably, the separated portion of the cover is folded inwards during the raising thereof, such that lateral portions of the side of the cover initially facing the carrier tape end up facing each other. The cross section of the folded portion of the cover will essentially assume the form of an inverted V or an M. Once folded, the cover will pass in an upright position at the side of the compartments being located at the picking position.

It should be noted that, although the above described embodiments for effecting said adjustment of the lateral position of the exposure member is the most preferred, other types of adjusting mechanisms may also be used, as readily envisaged by the person skilled in the art. Thus, the present invention is not restricted to a particular type of adjustment means.

Further details and aspects of the present invention will become apparent from the following description of preferred embodiments of the invention.

### Brief description of the drawings

Preferred embodiments of the invention will now be described in greater detail with reference to the accompanying drawings, in which
Fig. 1 illustrates the general relationship between a tape guide, a component tape, and a component tape holder of the present invention;
Fig. 2a is a perspective view and Fig. 2b is a phantom view showing the general structure of a component tape with a cardboard body;
Figs 3a-3e are plan views illustrating differently configured component tapes, and Figs 4a-4e are sectional views of the component tapes shown in Figs 3a-3e;
Fig. 5 illustrates the general structure of a prior art tape guide;
Fig. 6 illustrate three different prior art tape guides required for handling differently configured component tapes;
Fig. 7a illustrates the general structure of a tape guide according to one embodiment of the invention;
Figs 7b-7e are schematic transversal cross-sectional views taken at the four different sections of the tape guide shown in Fig. 7a, illustrating the process of exposing a component in a compartment of a component tape; and
Fig 7f is a close plan view illustrating a portion of the tape guide shown in Fig. 7a.

### Description of preferred embodiments

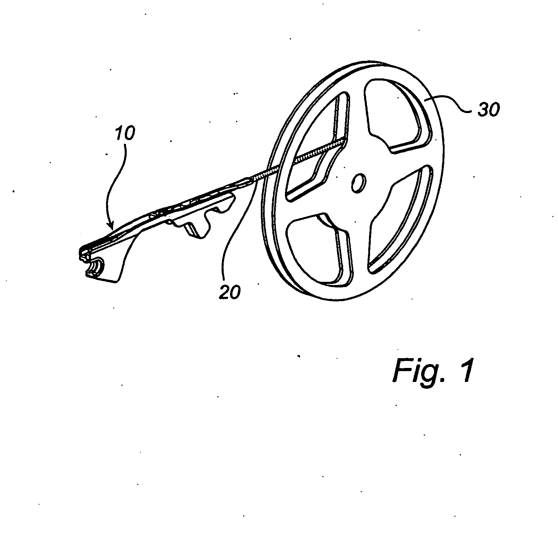

Preferred embodiments of the present invention are generally used in a system for providing components to a picking position in a component mounting machine, where the components can be picked and subsequently placed on a substrate, such as an electronic circuit board, by a pick-up head of the machine. Such a system generally comprises tape guides 10, component tapes 20 and component tape reels 30. In use, the component tapes 20 are wound onto component tape reels 30 and loaded into tape guides 10, as is illustrated in figure 1. The tape guides 10 are then mounted into a component mounting machine, or into a magazine for subsequent loading into a component mounting machine. According to the present invention, the tape guides are provided with adjustable exposure members, which will be described in more detail below.

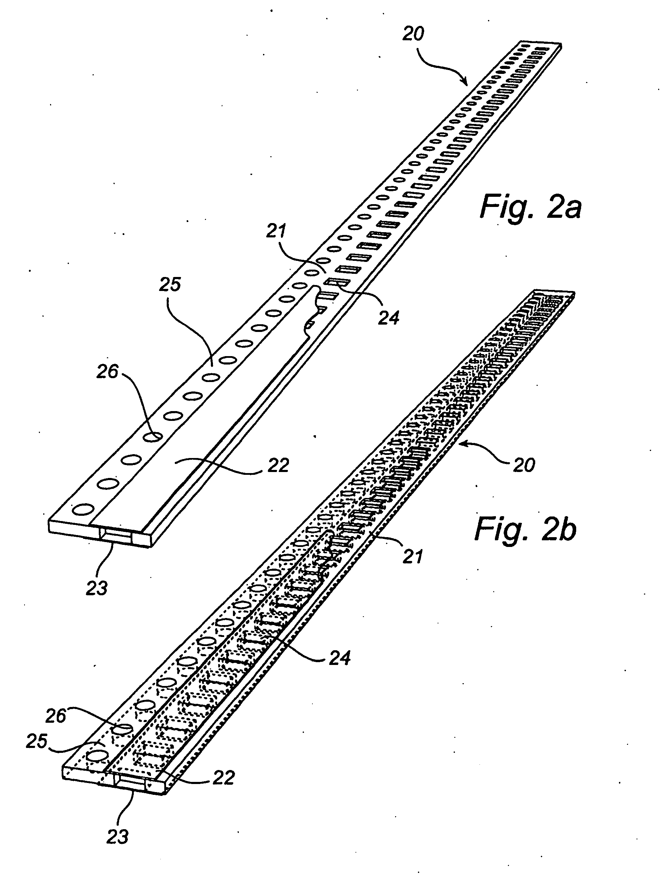

With reference to figures 2a-2b, 3a-3e and 4a-4e, the structure and varying configurations of component tapes will now be described. A component tape generally comprises two main parts, a carrier tape and a cover. The carrier tape comprises a card-board or plastic body 21 provided with compartments 24 for containing components, one in each compartment 24. For cardboard tapes, an example of which is illustrated in Figures 2a and 2b, the carrier tape also comprises a bottom cover 23 attached to the body 21 and extending along the entire length of the component tape 20, such that the body 21 and the bottom cover 23 together form the carrier tape for carrying components. Furthermore, the compartments 24 in cardboard tapes are provided as through holes 24 with the bottom cover 23 forming a bottom surface of the compartments. For plastic tapes, the body 21 normally constitutes the entire carrier tape of the component tape 20. The body 21 is further provided with a lateral portion 25 provided with through holes 26, which are arranged for engagement with a feeding device, said feeding device feeding the component tape 20 during the mounting procedure, normally in a component magazine.

As mentioned above, the component tape further comprises a cover 22, which generally consists of a thin, plastic, transparent sheath. The cover 22 is provided for enclosing the components contained in the compartments 24 and extends along the entire length of the component tape 20. Furthermore, the cover 22 is attached to the body 21 through the use of adhesive portions 27, 28, also referred to herein as attachment portions. Alternatively, the cover 22 may be fused to the body 21 along the illustrated portions 27, 28.

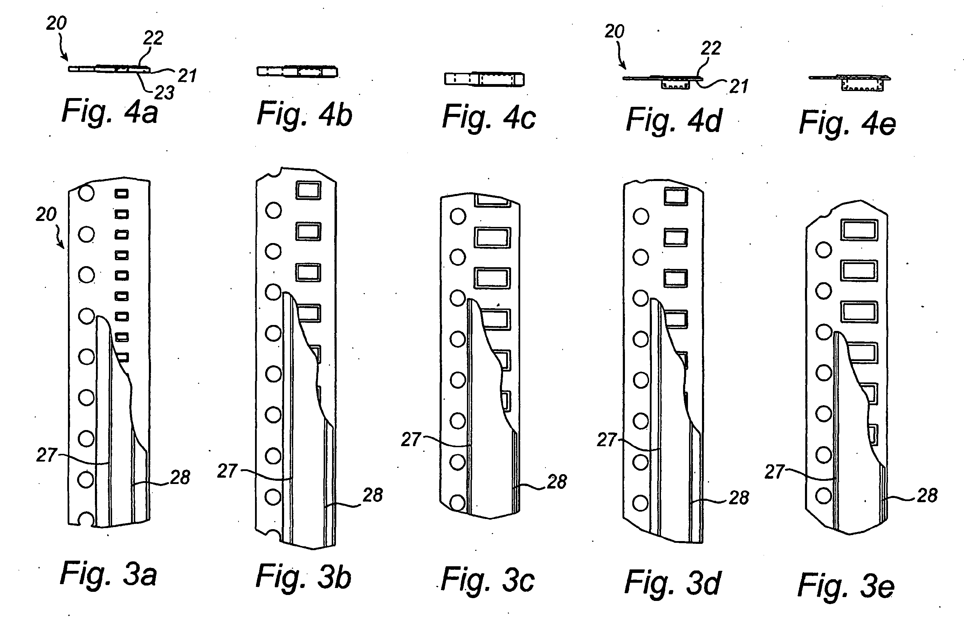

Turning to figures 3a-3e and 4a-4e, there is illustrated five examples of differently configured component tapes of the same component tape width, in which figures 3a-3c and 4a-4c illustrate cardboard tapes, whereas figures 3d-3e and 4d-4e illustrate plastic tapes. As can be seen in the figures, the cardboard tapes have the same thickness throughout the cardboard body 21, which is dependent on the depth of the compartment 24. The plastic tapes, however, have a thin lateral portion 25, the thickness of which generally not being dependent on the depth of the compartments.

Furthermore, and irrespective of the base material for the component tapes, the size of the compartments 24 can vary between component tapes of the same component tape width. However, according to standardization protocols, the distance from the edge of the component tape to the centre of each compartment has a standard value for each component tape width. Furthermore, the pitch of the compartments 24, i.e. the distance between adjacent or subsequent compartments, can be varied, see particularly figure 3a in which the distance between the compartments is reduced.

Finally, the cover 22 and the attachment thereof to the carrier tape 21 can be varied. Even though the covers shown all have the same width, which is the generally established design for component tapes, this is not necessarily so. The width may be varied in accordance with the width of the compartments. The figures illustrate different positions of the adhesive or fused portions 27, 28 in correspondence with the compartment width. The width of these portions may of course also be varied.

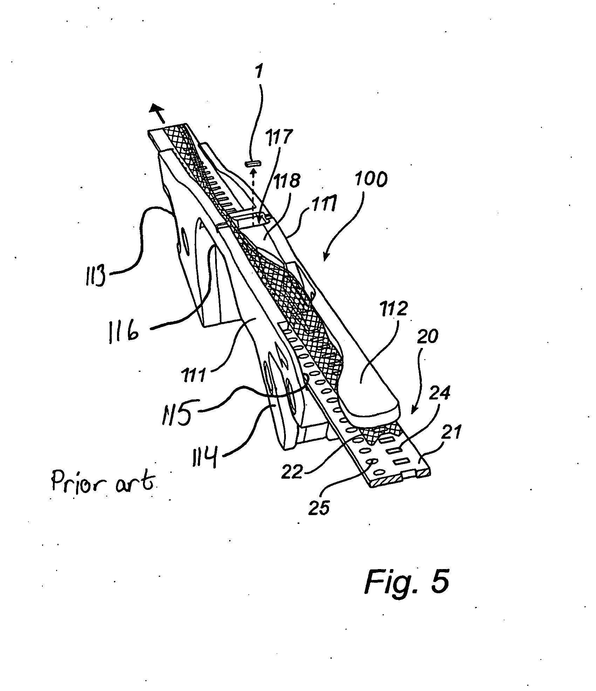

With reference now to figure 5, there is shown the general outline of a prior art tape guide, together with a section of a component tape 20 shown loaded into the tape guide 100. Generally, the tape guide comprises an elongated open-ended profile with opposing elongated tape guiding wall elements 111. The wall elements 111 are each provided with a longitudinal groove 115 for facilitating insertion of a component tape and guiding the component tape 20. The tape guide 100 is further provided with a recess 116 for enabling the pins or teeth of a feeding device, provided in a component mounting machine or in a magazine attached to a component mounting machine, to engage the feeding holes 26 of the component tape 20. A handle 112 is arranged in one end of the tape guide 100 for facilitating attachment and detachment of the tape guide 100 into and from the magazine of a component mounting machine. The tape guide 100 also comprises forward and rearward locking elements 113, 114 for attaching the tape guide into the magazine. For further details of the prior art tape guide reference is made to the International patent publication WO 00/38491.

During feeding of the component tape 20, in the feeding direction indicated by the arrow in figure 5, it passes an exposure member 118, which releases one side of the cover 22 from the carrier tape 21, along one of the attachment portions 27, 28, and brings or bends the released portion of the cover to an upright position. While the cover is in the upright position, the components are exposed in sequence at a picking position or slot 117 where the components can be picked by a pick-up head, as illustrated in the figure by the component 1.

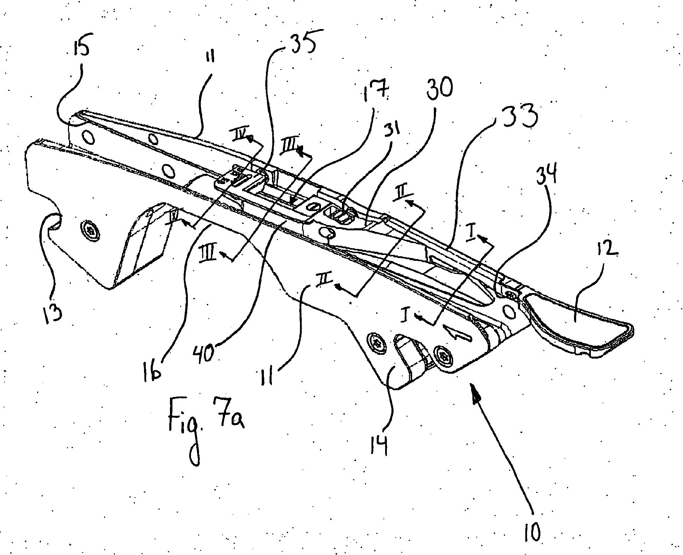

Alternatively, when handling components provided on wider component tapes, the cover is folded when bringing the tape to an upright position. This is in order to reduce the height of the raised cover, which otherwise might interfere with the movements of the pick-up head, or force the pick-up head to undue vertical movements in order to avoid the raised cover. A more detailed description of the raising and simultaneous folding of the cover follows below, in reference to embodiments of the present invention as illustrated in Figs. 7a-7f.

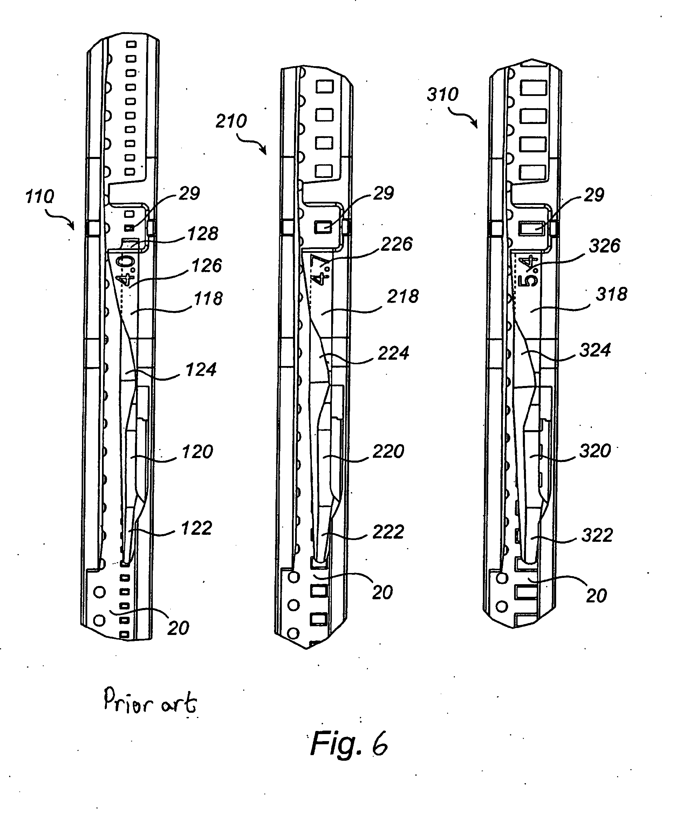

In figure 6, which comprises enlarged partial views of alternative prior art tape guides 100, such as explained in further detail in the European patent application published under EP 1 298 977, the exposure member 118 is shown in greater detail and in three different variants. In this illustration, a first tape guide 110 is arranged for small-sized compartments, a second tape guide 210 is arranged for medium-sized compartments, and a third tape guide 310 is arranged for large-sized compartments, all three variants being arranged for receiving and exposing components in component tapes having the same tape width.

The respective exposure member 118, 218, 318 comprises a forward or proximal, i.e. facing the component tape during feeding thereof, separating portion 120, 220, 320, which in turn comprises a tongue-shaped tip portion 122, 222, 322 for separating and lifting the cover 22 from the carrier tape 21, and a wing portion 124, 224, 324 for bringing the cover 22 into an upright position. Furthermore, the exposure member 118, 218, 318 comprises a covering portion 126, 226, 326, extending distally from the separating portion, for covering the component between the position of lifting the cover and the picking position 17.

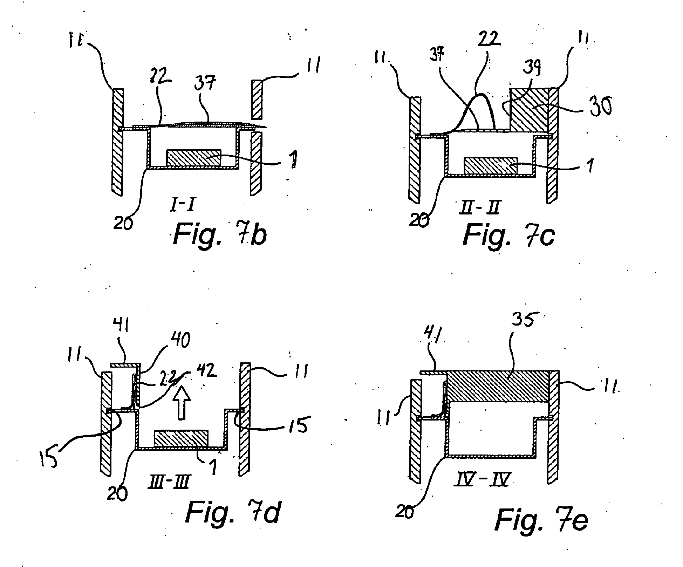

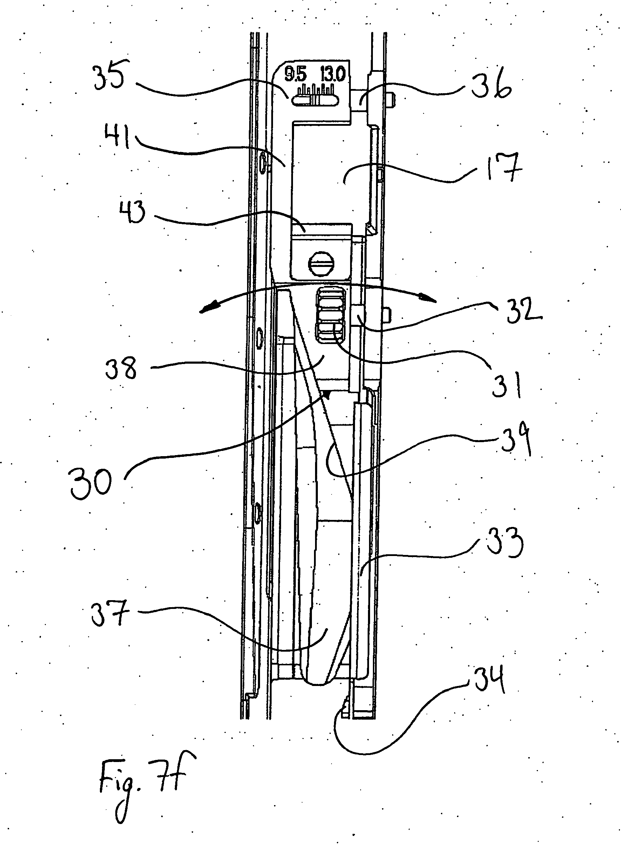

As is clearly illustrated by figure 7, the design of the respective exposure member 118, 218, 318 is adapted to the configuration of the respective component tape 20. Thus, for small compartments, the tip portion 122 is smaller, in particular as regards the width of the tip portion 122, than the tip portions 222, 322 for medium-sized and large compartments, respectively. Furthermore, the lateral extensions of the wing portions 124, 224, 324 varies between the three variants. This provides for complete exposure from the cover of a component at the picking position, while at the same time not separating the cover from the carrier tape on both sides of the compartments, even though the widths of the compartments vary.

The numbers provided at the forward end of the covering portion denote the distance in millimeters from the inner wall of the longitudinal groove 15 to the opposite lateral edge of the exposure member, which essentially corresponds to the lateral distance from the edge of the component tape 20 that the cover 22 is separated from the carrier tape 21. The illustrated tape guides are arranged for receiving component tapes having a width of 8 mm.

Also, the distal extensions of the respective covering portions 126, 226, 326 vary. Thereby, regardless of the compartment pitch, the compartment in turn to reach the picking position is completely covered by the covering portion 126, 226, 326 during the picking of a component in the previous compartment, while at the same time the previous compartment is completely exposed to a pick-up head.

Turning now to figures 7a-7f, there is shown a tape guide comprising an exposure member in accordance with the preferred embodiment of the present invention. The general outline of the tape guide corresponds essentially to that of the prior art tape guide 100 described in reference to Fig. 5 above. Thus, the wall elements 11, the longitudinal grooves 15, the recess 16, the handle 12, and the forward and rearward locking elements 13, 14 all have essentially the same structure and function as the corresponding wall elements 111, longitudinal grooves 115, recess 116, handle 112, and forward and rearward locking elements 113, 114 of the above described prior art tape guide 100.

The exposure member 30 according to the preferred embodiment of the present invention comprises means for adjusting the lateral and angular position of the exposure member in the form of an adjustment screw 31. The adjustment screw 31 is positioned in a position on top of the tape guide 10, which may be easily accessed and manipulated by an operator. The adjustment wheel 31 is mounted on an adjusting screw 32 which is in threaded engagement in a threaded through hole provided in the wall 11 of the tape guide 10. By turning the adjustment wheel 32, the adjusting screw 32 is screwed into or out of the wall 11 of the tape guide 10, and the exposure member 30 is laterally displaced, at least at the position of the adjustment wheel 31.

In this embodiment, the adjustment wheel is continuously adjustable, i.e. the exposure member may assume any position between the respective limit positions. The friction between the adjusting means and the tape guide is sufficiently high to maintain the setting of the adjustment wheel between subsequent adjustments by means of frictional coupling, but sufficiently low to enable easy change in settings by the operator.

Furthermore, the exposure member 30 comprises an elongated pivot arm 33 extending in a proximal direction as seen from the adjustment wheel 31. At the proximal end thereof, the pivot arm 33 is at 34 rigidly mounted to the side wall 11 of the tape guide 10. Since the pivot arm 33 is slightly flexible, the point 34 where the pivot arm 33 is rigidly mounted to the tape guide 10 acts as a pivot point 34. Thus, the entire exposure member 30 may be pivoted through the manipulation of the adjustment screw 31 about the pivot point 34. Thereby, not only the lateral position of the exposure member 30 is adjusted, but also the angular position thereof, which is indicated by the curved, double-headed arrow in Fig. 7f.

At the distal end of the exposure member 30, there is provided position indicating means comprising a scale 35 arranged on the exposure member and a position indicator 36 rigidly mounted in a wall of the tape guide 10. Thus, upon displacement of the exposure member 30, the scale 35 is displaced in relation to the position indicator 36 and the adjusted position can be registered by the operator. In this embodiment, the scaling presents an indication of the distance the cover is brought aside of the compartments as counted from the lateral edge of the component tape to the opposite lateral edge of the compartments. In other words, when handling a component tape where said distance is 10 millimetres, the operator adjusts the exposure member such that the scale 35 is set to 10. Since the scale 35 is provided at the far distal end of the exposure member 30, any lateral displacement at the picking position will of course provide an increased displacement of the scale 35, which facilitates the reading of the scale 35 and, hence, the setting of the exposure member 30.

Between the adjustment means and the position indicating means, there is provided an opening 17 in the exposure member 30, which indicates the picking position 17 and is thus arranged for providing access to the exposed components by a pick-up head or the like.

In order to effect the desired exposing of the compartments 24, the exposure member comprises a separating portion, which in turn comprises a tongue-shaped tip portion 37 for separating and lifting the cover 22 from the carrier tape 21, and a guiding portion for bringing the cover 22 to the side. Furthermore, the exposure member 30 comprises a covering portion 38, extending distally from the separating portion, for covering the component between the position of lifting the cover and the picking position 17.

The guiding portion has a guiding surface 39, which is substantially orthogonal to the tongue-shaped tip portion 37. The guiding surface 39 extends substantially from a first side to a second side of the tape guide 10, obliquely in the distal direction, in order to guide a loosened portion of the cover 22 to the side of the compartments at the picking position.

In the disclosed example of the preferred embodiment, the exposure member 30 is arranged such that as the loosened portion of the cover 22 is brought to the side of the sequence of components, tensions are introduced into the cover 22, which brings the cover 22 to be folded inwards. This folding is described in more detail below.

The exposure member 30 is also provided with a substantially vertical wall portion 40, which extends from the distal end of the guiding surface 39 distally along the side of the compartments 24 past the picking position 17. The vertical wall portion 40 ensures that the folded cover 22 remains folded and at the side of the picking position 17, while the cover passes the picking position 17. Thus, the components will be safely and completely exposed for picking by the pick-up head.

At the top end of and mounted to the wall 40, there is provided a horizontal wall portion 41 parallel to the carrier tape and arranged at the side of the picking position 17. The horizontal wall portion 41 covers the folded cover 22 as it passes the picking position 17 and forms a slot like passage with the vertical wall portion 40 and the tape guide wall 11.

Figs. 7b-7e are schematic cross-sectional views along the lines I-I, II-II, III-III, and IV-IV in Fig. 7a, respectively. The views illustrate the gathering by inwardly folding the cover 22, and the securing of the fold of the gathered cover 22 at the side of the picking position 17.

In Fig. 7b, the initial engagement between the tongue-shaped tip portion 37 of the exposure member 30 and the component tape is shown.

In Fig. 7c, the initial inward folding of the cover 22 is shown. One may note that, due to the tensions in the cover 22, the guiding surface 39 of the exposure member 30 is no longer in contact with the cover 17.

Fig. 7d illustrates the situation at the picking position 17. The folded cover 22 is kept at the side of the picking position 17, by the vertical wall portion 40, thus enabling the pick-up head to pick a component 1. The horizontal wall portion 41 keeps the gathered cover safely in the slot like passage formed between the vertical wall portion 40 and the wall 11 of the tape guide 10.

Fig. 7e illustrates the situation immediately following the picking position 17, the cover still being kept folded and to the side.

Additionally, in Figs. 7d and 7e there is illustrated a gap 42 between the upper surface of the carrier tape 21, on which the cover 22 is attached, and the lower edge of the vertical wall portion 40 of the exposure member 30. This gap 42 is provided in order to ensure that the cover 22 will not be separated from the carrier tape 21 along the second attachment portion 27, and obstruct the function of the exposure member 30, and hence prevent the carrier tape to be fed further along the tape guide. Furthermore, the size of the gap 42 is small in order to ensure that the loosened portion of the folded cover 22 does not slip back under the vertical wall portion 40, i.e. towards the picking position 22, thereby interfering with the component picking process.

The disclosed example concerns the handling of wider component tapes where a wide cover is folded when brought to the side, in order to avoid the drawbacks presented above in relation to merely bringing a wide cover to an upright position. However, the present invention is equally applicable to the handling of component tapes having a smaller width, i.e. where the raising of the cover to an upright position does not constitute a problem. Thus, even though not specifically shown, the exposure member 30 in accordance with the present invention may be used in a narrower tape guide, where the compartments are exposed in substantially the same manner as described above in relation to the prior art tape guide 100 shown in Fig. 5.

Furthermore, the exposure member 30 according to the disclosed embodiment of the present invention comprises a removable lid member 43 arranged immediately adjacent to the picking position 17. The removable lid member 43 is provided for increasing the opening in the exposure member 30 for access to components at the picking position 17 when removed, and for providing a cover under the lid member 43 for components otherwise exposed when the lid member 43 is mounted. Thus, the lid member 43 is mounted when components are provided in small pitch compartments, i.e. with a short distance between compartments, and removed when components are provided in compartments with large pitch. Thereby, the longitudinal extension, i.e. in the feeding direction of the component tape, of the covering portion 38 is either increased or reduced.

As understood by the person skilled in the art, although the adjustable exposure member of the present invention is intended for component tapes having the same component tape width, the invention is not restricted to a particular component tape width. Thus, the adjustable exposure member of the present invention is equally applicable any given component tape width.

Even though the invention has been described above using exemplifying embodiments thereof, alterations, modifications and combinations thereof, as understood by those skilled in the art, may be made within the scope of the accompanying claims.

## Claims

1. Exposure member (30) for exposing components at a picking position, the components (1) being provided on component tapes (20) comprising a carrier tape (21) and a cover (22), the components (1) being positioned in sequentially arranged compartments (24) provided on the carrier tape (21), the configuration of the compartments being dependent on the carried components, the cover (22) being attached to the carrier tape along first and second longitudinal attachment portions (27, 28) adjacent to the sequence of compartments (24) thereby enclosing the components,
wherein said exposure member (30) is arranged for separating the cover (22) from the carrier tape (21) along the first attachment portion (28) while leaving the cover (22) attached to the carrier tape (21) along the second attachment portion (27), and for bringing the cover (22) to one side of the compartment (24) at the picking position (17), and
**characterized in that** said exposure member (30) is adjustable so as to laterally displace the exposure member (30) at least at the picking position in relation to the longitudinal component tape (20) in adaptation to the configuration of the compartments (24), such that, at the picking position (17), the compartment (24) and the component (1) provided therein is completely exposed while the cover (22) remains attached to the carrier tape (21) along the second attachment portion (27).

2. The exposure member (30) as claimed in claim 1, wherein the entire exposure member (30) is laterally displaceable in relation to the longitudinal component tape (20), in adaptation to the width of the compartments (24).

3. The exposure member (30) as claimed in claim 1 or 2, wherein said exposure member (30) is angularly displaceable in relation to the longitudinal component tape (20), in adaptation to the width of the compartments (24).

4. The exposure member (30) as claimed in any one of claims 1-3, wherein the exposure member (30) comprises an adjustment wheel (31) for displacing the lateral position of the exposure member (30) at the picking position (17), said adjustment wheel (31) being arranged for manual manipulation by an operator.

5. The exposure member (30) as claimed in claim 4, wherein the adjustment wheel (31) is continuously adjustable.

6. The exposure member (30) as claimed in claim 4, wherein the adjustment wheel (31) is adjustable in distinct steps.

7. The exposure member (30) as claimed in any one of claims 4-6, wherein the position of the adjustment wheel between displacements is maintained by means of friction.

8. The exposure member (30) as claimed in any one of claims 4-7, wherein the adjustment wheel is provided with visual markings for identifying the position thereof.

9. The exposure member (30) as claimed in any one of the preceding claims, comprising a scale for visually indicating the adjustment setting of the exposure member.

10. The exposure member (30) as claimed in any one of the preceding claims, wherein the exposure member (30) is arranged to cover the compartment (24) from the proximal end of the exposure member (30) to the picking position (17).

11. The exposure member (30) as claimed in claim 10, comprising a lid member (43) arranged to be removably mounted at the picking position (17), such that the distance that the exposure member (30) covers the compartments (24) is extended when the lid member (43) is mounted, and reduced when the lid member (43) is removed from the exposure member (30), in adaptation to the longitudinal extension of the compartments (24) and/or the distance between the compartments (24).

12. A tape guide (10) for guiding component tapes (20) of the same component tape width in a component mounting machine, **characterized in that** the tape guide (10) comprises an exposure member (30) as claimed in any one of the preceding claims.

13. The tape guide (10) as claimed in claim 12, wherein the tape guide (10) is formed as a self-contained unit to be releasably mounted at the component mounting machine.

14. The tape guide (10) as claimed in claim 12 or 13, wherein the tape guide (10) lacks component tape feeding means and is arranged for allowing component tape feeding means arranged at or in the component mounting machine to engage with the carrier tape (20) for feeding the carrier tape (20) towards the picking position (17).

15. The tape guide (10) as claimed in any one of claims 12-14, wherein the exposure member (30) is pivotally mounted in the tape guide (10) with the pivot point located at the proximal end of the exposure member (30), such that adjustment of the exposure member (30) brings about a pivotal movement whereby the lateral position of the exposure member (30) at the picking position is adjusted.

## Patentansprüche

1. Aussetzelement (30) zum Aussetzen von Schaltelementen an einer Entnahmeposition, wobei die Schaltelemente (1) auf Schaltelementbändern (20), die ein Trägerband (21) und eine Abdeckung (22) umfassen, vorgesehen sind; die Schaltelemente (1) in aufeinander folgend angebrachten Fächern (24), die auf dem Trägerband (21) vorgesehen sind, angeordnet sind; die Ausführung der Fächer von den transportierten Schaltelementen abhängig ist; die Abdeckung (22) an dem Trägerband entlang der der Folge von Fächern (24) benachbarten ersten und zweiten Längsbefestigungsabschnitte (27, 28) befestigt ist, wodurch die Schaltelemente umschlossen werden;
wobei das Aussetzelement (30) angebracht ist, um die Abdeckung (22) von dem Trägerband (21) entlang des ersten Befestigungsabschnitts (28) zu trennen, während die Abdeckung (22) an dem Trägerband (21) entlang des zweiten Befestigungsabschnitts (27) befestigt gelassen wird, und um die Abdeckung (22) an die eine Seite des Faches (24) an der Entnahmeposition (17) zu bringen; und
**dadurch gekennzeichnet, dass** das Aussetzelement (30) einstellbar ist, um bei einer Anpassung an die Ausführung der Fächer (24) das Aussetzelement (30) zumindest an der Entnahmeposition in Bezug auf das Schaltelement-Längsband (20) seitlich zu verschieben, so dass an der Entnahmeposition (17) das Fach (24) und das darin vorgesehene Schaltelement (1) vollständig ausgesetzt sind, während die Abdeckung (22) an dem Trägerband (21) entlang des zweiten Befestigungsabschnitts (27) befestigt bleibt.

2. Aussetzelement (30) nach Anspruch 1, wobei das gesamte Aussetzelement (30) bei Anpassung an die Breite der Fächer (24) in Bezug auf das Schaltelement-Längsband (20) seitlich verschiebbar ist.

3. Aussetzelement (30) nach Anspruch 1 oder 2, wobei das Aussetzelement (30) bei Anpassung an die Breite der Fächer (24) in Bezug auf das Schaltelement-Längsband (20) winklig verschiebbar ist.

4. Aussetzelement (30) nach einem der Ansprüche 1 bis 3, wobei das Aussetzelement (30) ein Einstellrad (31) zum Verschieben der seitlichen Position des Aussetzelements (30) an der Entnahmeposition (17) umfasst, das Einstellrad (31) zur manuellen Betätigung durch eine Bedienperson angebracht ist.

5. Aussetzelement (30) nach Anspruch 4, bei dem das Einstellrad (31) kontinuierlich einstellbar ist.

6. Aussetzelement (30) nach Anspruch 4, bei dem das Einstellrad (31) in bestimmten Schritten einstellbar ist.

7. Aussetzelement (30) nach einem der Ansprüche 4 bis 6, bei dem die Position des Einstellrades zwischen Verschiebungen durch Reibung beibehalten wird.

8. Aussetzelement (30) nach einem der Ansprüche 4 bis 7, bei dem das Einstellrad mit sichtbaren Markierungen zum Erkennen der Position desselben versehen ist.

9. Aussetzelement (30) nach einem der vorhergehenden Ansprüche, das eine Skale zur sichtbaren Anzeige der Justiereinstellung des Aussetzelements umfasst.

10. Aussetzelement (30) nach einem der vorhergehenden Ansprüche, wobei das Aussetzelement (30) angeordnet ist, um das Fach (24) von dem proximalen Ende des Aussetzelements (30) bis zu der Entnahmeposition (17) zu bedecken.

11. Aussetzelement (30) nach Anspruch 10, umfassend ein Deckelelement (43), das angebracht ist, um es an der Entnahmeposition (17) entfernbar zu montieren, so dass bei einer Anpassung an die Längsausdehnung der Fächer (24) und/oder den Abstand zwischen den Fächern (24) der Abstand, mit dem das Aussetzelement (30) die Fächer (24) bedeckt, verlängert wird, wenn das Deckelelement (43) montiert ist, und verringert wird, wenn das Deckelelement (43) von dem Aussetzelement (30) entfernt ist.

12. Bandführung (10) zum Führen von Schaltelementbändern (20) derselben Schaltelementband-Breite in einer Bestückungsmaschine, **dadurch gekennzeichnet, dass** die Bandführung (10) ein Aussetzelement (30) nach einem der vorhergehenden Ansprüche aufweist.

13. Bandführung (10) nach Anspruch 12, wobei die Bandführung (10) als eine in sich geschlossene Einheit ausgebildet ist, die an der Bestückungsmaschine lösbar montiert wird.

14. Bandführung (10) nach Anspruch 12 oder 13, wobei die Bandführung (10) keine Schaltelementband-Zuführeinrichtungen besitzt und so eingerichtet ist, um Schaltelementband-Zuführeinrichtungen an oder in der Bestückungsmaschine zum Eingriff mit dem Trägerband (20) anzuordnen, damit das Trägerband (20) zu der Entnahmeposition (17) hin beschickt wird.

15. Bandführung (10) nach einem der Ansprüche 12 bis 14, bei der das Aussetzelement (30) drehbar in der Bandführung (10) angebracht ist, wobei der Drehpunkt am proximalen Ende des Aussetzelementes (30) angeordnet ist, so dass eine Justierung des Aussetzelements (30) eine Drehbewegung bewirkt, wodurch die seitliche Position des Aussetzelements (30) an der Entnahmeposition eingestellt wird.

## Revendications

1. Elément d'exposition (30) pour exposer des composants dans une position de prélèvement, les composants (1) étant prévus sur des bandes de composant (20) comprenant une bande de support (21) et un couvercle (22), les composants (1) étant positionnés dans des compartiments (24) agencés de manière séquentielle prévus sur la bande de support (21), la configuration des compartiments dépendant des composants transportés, le couvercle (22) étant fixé sur la bande de support le long des premières et secondes parties de fixation longitudinale (27, 28) adjacentes à la séquence de compartiments (24) enfermant ainsi les composants,
dans lequel ledit élément d'exposition (30) est agencé pour séparer le couvercle (22) de la bande de support (21) le long de la première partie de fixation (28) tout en laissant le couvercle (22) fixé sur la bande de support (21) le long de la seconde partie de fixation (27) et pour amener le couvercle (22) sur un côté du compartiment (24) à la position de prélèvement (17), et
**caractérisé en ce que** ledit élément d'exposition (30) est ajustable afin de déplacer latéralement l'élément d'exposition (30) au moins à la position de prélèvement par rapport à la bande (20) de composant longitudinale en adaptation par rapport à la configuration des compartiments (24), de sorte qu'à la position de prélèvement (17), le compartiment (24) et le composant (1) prévu dans celui-ci, est complètement exposé alors que le couvercle (22) reste fixé sur la bande de support (21) le long de la seconde partie de fixation (27).

2. Elément d'exposition (30) selon la revendication 1, dans lequel tout l'élément d'exposition (30) peut être déplacé latéralement par rapport à la bande de composant longitudinale (20), en adaptation avec la largeur des compartiments (24).

3. Elément d'exposition (30) selon la revendication 1 ou 2, dans lequel ledit élément d'exposition (30) peut être déplacé de manière angulaire par rapport à la bande de composant longitudinale (20) en adaptation par rapport à la largeur des compartiments (24).

4. Elément d'exposition (30) selon l'une quelconque des revendications 1 à 3, dans lequel l'élément d'exposition (30) comprend une roue de réglage (31) pour déplacer la position latérale de l'élément d'exposition (30) à la position de prélèvement (17), ladite roue de réglage (31) étant adaptée pour la manipulation manuelle par un opérateur.

5. Elément d'exposition (30) selon la revendication 4, dans lequel la roue de réglage (31) est réglable de manière continue.

6. Elément d'exposition (30) selon la revendication 4, dans lequel la roue de réglage (31) est réglable dans des étapes distinctes.

7. Elément d'exposition (30) selon l'une quelconque des revendications 4 à 6, dans lequel la position de la roue réglable entre les déplacements est maintenue au moyen du frottement.

8. Elément d'exposition (30) selon l'une quelconque des revendications 4 à 7, dans lequel la roue de réglage est prévue avec des marques visuelles pour identifier sa position.

9. Elément d'exposition (30) selon l'une quelconque des revendications précédentes, comprenant une échelle pour indiquer visuellement le réglage de l'élément d'exposition.

10. Elément d'exposition (30) selon l'une quelconque des revendications précédentes, dans lequel l'élément d'exposition (30) est agencé pour recouvrir le compartiment (24) de l'extrémité proximale de l'élément d'exposition (30) jusqu'à la position de prélèvement (17).

11. Elément d'exposition (30) selon la revendication 10, comprenant un élément formant couvercle (43) agencé pour être monté de manière amovible dans la position de prélèvement (17), de sorte que la distance sur laquelle l'élément d'exposition (30) recouvre les compartiments (24) est étendue lorsque l'élément formant couvercle (43) est monté, et réduite lorsque l'élément formant couvercle (43) est retiré de l'élément d'exposition (30), en adaptation par rapport à l'extension longitudinale des compartiments (24) et/ou la distance entre les compartiments (24).

12. Guide de bande (10) pour guider des bandes de composant (20) de la même largeur de bande de composant dans une machine de montage de composant, **caractérisé en ce que** le guide de bande (10) comprend un élément d'exposition (30) selon l'une quelconque des revendications précédentes.

13. Guide de bande (10) selon la revendication 12, dans lequel le guide de bande (10) est formé comme une unité autonome pour être montée de manière amovible dans la machine de montage de composant.

14. Guide de bande (10) selon la revendication 12 ou 13, dans lequel le guide de bande (10) manque de moyens d'alimentation de bande de composant et est agencé pour permettre aux moyens d'alimentation de bande de composant agencé au niveau de ou dans la machine de montage de composant de se mettre en prise avec la bande de support (20) pour alimenter la bande de support (20) vers la position de prélèvement (17).

15. Guide de bande (10) selon l'une quelconque des revendications 12 à 14, dans lequel l'élément d'exposition (30) est monté de manière pivotante dans le guide de bande (10) avec le point de pivot situé au niveau de l'extrémité proximale de l'élément d'exposition (30) de sorte que le réglage de l'élément d'exposition (30) provoque un mouvement pivotant moyennant quoi on ajuste la position latérale de l'élément d'exposition (30) à la position de prélèvement.
